Europäisches Patentamt

European Patent Office

Office européen des brevets

(11) Publication number: 0 380 877
A2

# EUROPEAN PATENT APPLICATION

(21) Application number: 89312957.7

(22) Date of filing: 12.12.89

(51) Int. Cl.⁵: G03F 7/00

(30) Priority: 12.12.89 JP 314644/88
28.01.89 JP 19065/89
28.01.89 JP 19069/89
30.01.89 JP 20404/89

(43) Date of publication of application:
08.08.90 Bulletin 90/32

(84) Designated Contracting States:
DE FR GB

(71) Applicant: BROTHER KOGYO KABUSHIKI
KAISHA
35, 9-chome, Horita-dori Mizuho-ku
Nagoya-shi, Aichi-ken(JP)

(72) Inventor: Kuwabara, Satoru c/o Brother Kogyo
K. K.
No. 35, Horitadori 9-chome Mizuho-ku
Nagoya-shi Aichi-ken(JP)
Inventor: Sakakibara, Kenji c/o Brother Kogyo
K. K.
No. 35, Horitadori 9-chome Mizuho-ku
Nagoya-shi Aichi-ken(JP)
Inventor: Ueda, Masashi c/o Brother Kogyo K.
K.
No. 35, Horitadori 9-chome Mizuho-ku
Nagoya-shi Aichi-ken(JP)
Inventor: Katoh, Tokunori c/o Brother Kogyo
K. K.
No. 35, Horitadori 9-chome Mizuho-ku
Nagoya-shi Aichi-ken(JP)
Inventor: Hatta, Naoyuki c/o Brother Kogyo K.
K.
No. 35, Horitadori 9-chome Mizuho-ku
Nagoya-shi Aichi-ken(JP)

(74) Representative: Senior, Alan Murray et al
J.A. KEMP & CO 14 South Square Gray's Inn
London WC1R 5EU(GB)

(54) Color image recording apparatus.

(57) In a color image recording apparatus using a photosensitive recording medium, an image of an original document is irradiated by a light emitted from an exposure lamp and the imaging light is applied to the photosensitive recording medium. In order to compensate for the performance of an exposure lamp, a color temperature or a spectrum distribution of the light emitted from the lamp is sensed, and in response to the sensed value, the light components of the imaging light are adjusted by filters, or by varying the voltage applied to the exposure lamp, thereby adjusting the color temperature of the light emitted from the lamp to a desirable value.

FIG. 1

# COLOR IMAGE RECORDING APPARATUS

The present invention relates generally to a color image recording apparatus, and more particularly to a color image recording apparatus having a photo-sensor for sensing a light emanated from an exposure lamp.

In a color image recording apparatus of the type using a photosensitive recording medium, a light emitted from an exposure lamp is irradiated onto an original document and a light reflected therefrom is applied onto the photosensitive recording medium to form a latent image thereon. While it is ideal that the exposure lamps have intended performance, they have in actuality different performances. Even if the performances are substantially the same, they tend to be varied due to aging or other reasons. If such variations in performance of the exposure lamps become notable, the spectrum waveform of the light emanated from the lamp changes greatly. Since the color reproducibility of the photosensitive recording medium is determined by the spectrum distribution or color temperature of the applied light, the variation in performance of the exposure lamp causes to vary the color tone of the reproduced color copy.

The present invention has been made in view of the foregoing, and it is an object of the invention to provide a color image recording apparatus in which the color copies obtained have fixed color balance regardless of the presence of variation in performance of an exposure lamp.

In order to achieve the above and other objects of the invention, according to one aspect of the invention, there is provided a color image recording apparatus for recording an image of an original document on a photosensitive recording medium, a coloring degree the image recorded on the recording medium being changed depending on a color temperature of light applied to the recording medium, the apparatus comprising a light source for emitting a light, the light being irradiated onto the original document and a light reflected from the original document being applied through an optical path to the photosensitive recording medium to form a latent image thereon corresponding to the image of the original document, adjusting means disposed in the optical path for adjusting color components of the light reflected from the original document, sensing means for sensing a color temperature of the light emitted from the light source, the sensing means outputting a detection signal indicative of the sensed color temperature, and control means responsive to the detection signal for controlling the adjusting means so that the color components of the light reflected from the original document are set to substantially constant, whereby variation in performance of the light source can be compensated for.

The apparatus may further include a power supply for supplying a voltage, the light source being supplied with the voltage, first switch means connected between the power supply and the light source, the first switch means being rendered ON when the image recording is performed otherwise being rendered OFF, and second switch means connected between the control means and the light source, the second switch means being rendered ON when the image recording is performed, wherein the first switch means is rendered OFF when the control means determines based on the detection signal that the light is being emitted from the light source out of a period when the image recording is performed.

According to another aspect of the invention, there is provided a color image recording apparatus for recording an image of an original document on a photosensitive recording medium, a coloring degree of the image recorded on the recording medium being changed depending on a color temperature of light applied to the recording medium, the apparatus comprising a power supply for supplying a voltage, a light source coupled to the power supply for emitting a light depending on the voltage supplied thereto by the power supply, the light being irradiated onto the original document and a light reflected from the original document being applied through an optical path to the photosensitive recording medium to form a latent image thereon corresponding to the image of the original document, sensing means for sensing a color temperature of the light emitted from the light source, the sensing means outputting a detection signal indicative of the sensed color temperature, and control means responsive to the detection signal for controlling the voltage supplied to the light source by the power supply so that the color temperature of the light emitted from the light source is set at a predetermined value, whereby variations in performance of the light source can be compensated for.

According to further aspect of the present invention, when the detection signal is less than a predetermined valve, the control means determines that a malfunction has been occurred, and the occurrence of the malfunction is displayed on a display.

According to still another aspect of the present invention, there is provided a color image recording apparatus for recording an image of an original document on a photosensitive recording medium, a coloring degree of the image recorded on the recording medium being changed depending on a color temperature of light applied to the recording medium, the apparatus comprising a power supply for supplying a voltage, a light source coupled to the power supply for emitting a light, the light being irradiated onto the original document and a light reflected from the original document being applied through an optical path to the photosensitive recording medium to form a latent image thereon corresponding to the image of the original document, sensing means for sensing an amount of light emitted from the light source, the sensing means outputting a detection signal indicative of the sensed light amount, and control means responsive to the detection signal for comparing the detection signal with a predetermined value, wherein when the detection signal is smaller than the predetermined value, the control means determines that a malfunction is occuring in at least one of the power supply and the light source.

A reference member may be disposed to receive the light emitted from the light source and the sensor may receive the light reflected from thje reference member. In the case of provision of the reference member, the light reflected therefrom indicates the light emitted from the light source.

The sensing means senses the light emitted from the light source or the light reflected from the reference member to thereby detect the color temperature of the light emitted from the light source. In response to the detection signal fed from the sensor means, the control means automatically controls the adjusting means, such as filters disposed between the light source and the photosensitive recording medium, to adjust the light components of the light reflected from the original document so as to have a desirable color temperature or spectrum distribution.

In stead of adjusting the filters, the voltage applied to the light source may be varied to have the desirable color temperature.

The above and other objects, features and advantages of the present invention will become more apparent from the following description when taken in conjunction with the accompaning drawings in which preferred embodments of he present invention are shown by way of illustrative examples.

Fig. 1 is a vertical cross-sectional view showing a color image recording apparatus according to the present invention;

Fig. 2 is a block diagram illustrating a first embodiment of the present invention;

Fig. 3 is a block diagram illustrating a second embodiment of the present invention;

Fig. 4 is a block diagram illustrating a third embodiment of the present invention;

Fig. 5 is a flow chart illustrating an operational sequence of a microcomputer incorporated in the circuit shown in Fig. 4;

Fig. 6 is a flow chart illustrating an operational sequence of a microcomputer incorporated in the circuit shown in Fig. 4;

Fig. 7 is a block diagram illustrating a fourth embodiment of the present invention;

Fig. 8 is a block diagram further illustrating the fourth embodiment of the present invention; and

Fig. 9 is a flow chart illustrating an operational sequence of a microcomputer incorporated in the circuit shown in Fig. 7.

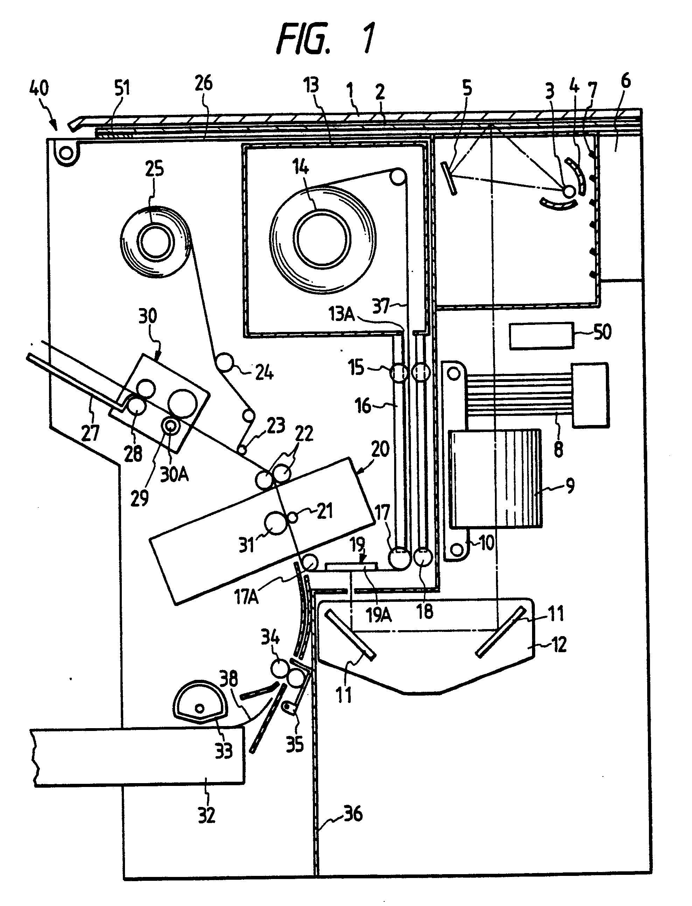

Fig. 1 shows an image recording apparatus capable of performing a full-color recording or copying. In this apparatus, a transfer type image recording medium as disclosed in U.S. Patent 4,399,209 to Sanders et al is used. Briefly, this recording medium (hereinafter referred to as " microcapsule sheer") is coated with an immense number of microcapsules on one surface thereof. The microcapsule encapsulates photo-curing (or photo-softening) resin and a chromogenic material of one of three primary colors, i.e. cyan, magenta and yellow, There is a separate image receiving sheet (hereinafter referred to as "developer sheet") having a surface coated with a developer material. When the microcapsule sheet is selectively exposed to light, the mechanical strength of the microcapsules in the exposed area is changed from soft to hard or vice versa to thereby form a latent image thereon corresponding to the pattern of the exposure. The latent image on the microcapsule sheet is developed under pressure to provide a visible image on the developer sheet by rupturing the microcapsules of weaker mechanical strength and having the chromogenic material released therefrom react with the developer material.

Referring to Fig. 1, a light shielding partition plate 36 is disposed in the apparatus 40 to spacedly divide the apparatus into two chambers. That is, a light source unit and an optical system are disposed within one chamber whereas other requisite units, such as a pressure developing and thermal fixing units, are disposed within the other chamber.

An elongated web-like microcapsule sheet 37 wound around a cartridge shaft 14 is retained in a microcapsule sheet cartridge 13 that is detachably disposed at a position immediately below an original support pane 2 and is formed with a bottom opening 13A. An exposure unit 19 is disposed below the sheet cartridge 13 at a downstream side thereof. The sheet 37 passes through a number of rollers and a pressure developing unit 20, and a leading end of the sheet 37 is attached to a take-up shaft 25 positioned beside the sheet cartridge 13. Between the sheet cartridge 13 and the exposure unit 19, feed roller 15 and a barrel roller 17 are rotatably provided at a vertical sheet path for guide travel of the sheet toward the exposure unit 19. At the downstream of the exposure unit 19, there is provided the pressure developing unit 20 which includes a small-diameter roller 21 and a backup roller 31.

At a lower portion of the apparatus 40, there is provided a developer sheet cassette 32 for storing therein a stack of developer sheets 38. Immediately above the cassette 32, a sector roller 33 is provided to feed the uppermost developer sheet 38 toward the pressure developing unit 20. Between the cassette 32 and the pressure developing unit 20, a roller 34 and a registration gate 35 are provided so as to align the leading edge of the developer sheet 38.

At downstream of the pressure developing unit 20, a pair of feed rollers 22 are provided so as to transport the sheet at a constant speed. This speed is coincident with a horizontally moving speed of the original support pane 2. At downstream of the feed rollers 22, a separation roller 23 is provided at which the microcapsule sheet 37 is separated from the developer sheet 38. The separated microcapsule sheet 37 is taken-up by the take-up shaft 25 through a meander travel control roller 24. On the other hand, a thermal fixing unit 30 is provided at the downstream of the separation roller 23. The thermal fixing unit 30 includes a hollow heat roller 29, in the interior of which a heater element 30A is disposed. Further, a pair of feed rollers 28 are provided to feed the image fixed developer sheet 38 toward a discharge tray 27.

Next, an optical system and optical path in the apparatus 40 will be described. As shown, the apparatus 40 has its top plate portion provided with a cover member 1 and the original support pane 2. The original support pane 2 is formed of a light transmissive material and is movable in the horizontal direction and on which an original document (not shown) is placed face down. At the upper right side of the apparatus 40, fixedly provided is a halogen lamp 3 extending in the direction perpendicular to the sheet of drawing, and a semicylindrically shaped reflector 4 is disposed to surround the lamp 3. The halogen lamp 3 emits a light toward the original support pane 2.

Therefore, the light emitted from the halogen lamp 3 can be sequentially irradiated onto the entire surface over the region from one to the other end of the original support pane 2 as the original support pane 2 moves horizontally. The light from halogen lamp 3 passes through the transparent original support pane 2 and is reflected from the original placed thereon. The cover member 1 is provided to prevent this light from leaking out of the apparatus. To irradiate the light from the halogen lamp 3 onto the original at a high efficiency, a flat reflector 5 is disposed to face the halogen lamp 3 and receive the light from the lamp 3 and directs it toward the original document. At the rear side of the halogen lamp 3, there are provided a fan 6 and a louver 7 for introducing an external air into the apparatus, with which air is effectively impinged upon the lamp 3 to cool the same.

A filter unit 8 having a plurality of filter elements is disposed below the original support pane 2. Further, a lens unit 9 is provided below the filter unit 8. Light emitted from the halogen lamp 3 and reflected from the original document passes through the filter elements 8 and enters the lens 9. The filter elements 8 alter the light transmissive characteristic in accordance with the sensitivity characteristics of the microcapsule sheet 37, to thereby adjust the color tone of a copied output image. The lens 9 is fixedly secured to a lens mounting plate 10, and fine angular adjustment of this lens with respect to a light path is achievable.

A pair of reflection mirrors 11 are provided below the lens 9. The focused light which has passed through the lens 9 changes its direction by 180 degrees (completely reverse direction) by the two reflection mirrors 11, and the thus oriented light is applied to the microcapsule sheet 37 closely contacting the bottom of an exposure table 19A to form the latent image thereon. The two reflection mirrors 11 are securely mounted to a mirror mounting plate 12. The mirror mounting plate 12 is vertically movably provided so that the adjustment of the distance of the light path and focusing adjustment can be effected by fine adjustment of the position of the mirror mounting plate 12. The original, the filter 8, the lens 9, the pair of reflection mirrors 11 and the exposure table 19A define a U-shape or J-shape light path in combination. That is, the optical path is bent into U-shape or J-shape, which path comprises a first vertical path directed downwardly, a second path directed horizontally and a third path directed upwardly. At the first optical path, the light reflected from the original is oriented downwardly, and at the third path the light is directed toward the imaging surface of the microcapsule sheet 37 at the exposure zone 19A, and the reflection mirror unit (11, 12) is disposed at the second optical path extending in horizontal direction. When the mirror mounting plate 12 is downwardly moved by a certain distance, the total light path distance is increased by a distance twice as long as the moving distance of the plate 12, yet maintaining the focusing position on the exposure zone 19A unchanged.

The mirror mounting plate 12 can maintain relative angular positional relationship between the pair of mirrors 11 regardless of the vertical movement of the plate 12. Accordingly, the plate 12 fixedly mounting the two mirrors can be simply assembled to the recording apparatus 40 as those can be treated as a single integral unit. It should be noted that only the pair of reflection mirrors 11 are required to obtain a normal upstanding or erect imaging direction at the exposure zone 19A, since the light is finally applied to the exposure zone upwardly, i.e, the microcapsule sheet 37 is exposed to light at the exposure zone 19A with the microcapsule coated surface facing down.

Operation of the apparatus 40 arranged as above will be described.

The microcapsule sheet 37 drawn out from the opening 13A of the cartridge 13 is fed by the feed rollers 15 and guided by the barrel roller 17. The sheet 37 then passes while contacting the lower face of the exposure table 19A where imaging light is applied to the sheet 15, so that a latent image is formed on the sheet 37.

More specifically, the cover member 1 is lifted up for placing the original document on the original support pane 2. Then, when a start button (not shown) is depressed, the original support pane 2 is moved to one direction (rightwardly in Fig. 1), so that one side edge of the pane 2 (left side edge in Fig. 1) stops at a first position where the one side edge of the pane 2 is coming into confrontation with the light source. Thereafter, with the halogen lamp 3 being lit, the original support pane 2 is then moved in a second direction (leftwardly in Fig. 1) opposite to the first direction. The light emitted from the halogen lamp 3 is reflected from the original, and the light reflected therefrom passes through the filter 8 and lens 9 and is reflected at the two reflection mirrors 11. The last reflected light is finally directed toward the microcapsule sheet 37 which is located under the exposure table 19A, thereby forming a latent image on the sheet 37. At this time, since the microcapsule sheet 37 is moved under the exposure table 19A in the second direction (leftwardly in Fig. 1) at the same speed as the moving speed of the original support pane 2, the latent image corresponding to the original image is formed on the microcapsule sheet 37 at an equi-magnitude. Since the conveying speed of the microcapsule sheet 37 is controlled to be constant by feed rollers 22 and is set equal to the moving speed of the original support pane 2, line latent images having given widths are sequentially formed on the microcapsule sheet 37 that is passing along the lower surface of the exposure table 19A.

The sheet 37 is then fed to the pressure developing unit 20 by the guide roller 17. At the pressure developing unit 20, the sheet 37 and the developer sheet 38 are held in facial contact with each other and are applied with pressure to develop the latent image and form a visible image on the developer sheet 38. The microcapsule sheet 37 leaving from the cartridge 13 is kept unexposed to light due to the presence of a shielding cover 16. The developer sheets 38 are fed out one by one by the sector roller 33, and each sheet 38 is fed to a sheet inlet of the pressure developing unit 20 after the leading edge of the sheet 38 is aligned by developer sheet rollers 34 and the registration gate 35.

The microcapsule coated surface of the sheet 37 on which a latent image is formed contacts the developer coated surface of the developer sheet 38 inside the pressure developing unit 20, and these superposed sheets are pressed together by the small-diameter roller 21 and the backup roller 31. Unexposed microcapsules are ruptured by the pressure applied, to thereby form an output image on the developer sheet 38 due to the reaction of the chromogenic material released from the ruptured microcapsules with the developer material.

In summary, in timed relation with the movement of the original support pane 2 in the second direction, the sector roller 33 feeds out the developer sheets 38 one by one from the developer sheet cassette 32. The developer sheet 37 is brought to facial contact with the exposed microcapsule sheet 37 and the both sheets are fed to the pressure developing unit 20 in which the latent image on the microcapsule sheet 37 is developed and transferred onto the developer sheet 38.

The microcapsule sheet 37 and developer sheet 38 leaving from the pressure developing unit 20 are fed out by the feed rollers 22 and are separated by the separation roller 23, the former sheet 37 directing upward and the latter sheet 38 directing in the straight direction. Thereafter, the developer sheet 38 is subjected to thermal fixing in the thermal fixing unit 30 and is then discharged onto the discharge tray 27 face up. The microcapsule sheet 37 leaving from the pressure developing unit 20 and passing through the separation roller 23 and the meandering control roller 24 is wound around the take-up shaft 25. When the movement of the original support pane 2 is stopped at a second position where another edge (right side in Fig. 1) of the pane 2 confronts the light source, the scanning of the original document is completed and the halogen lamp 3 is turned off.

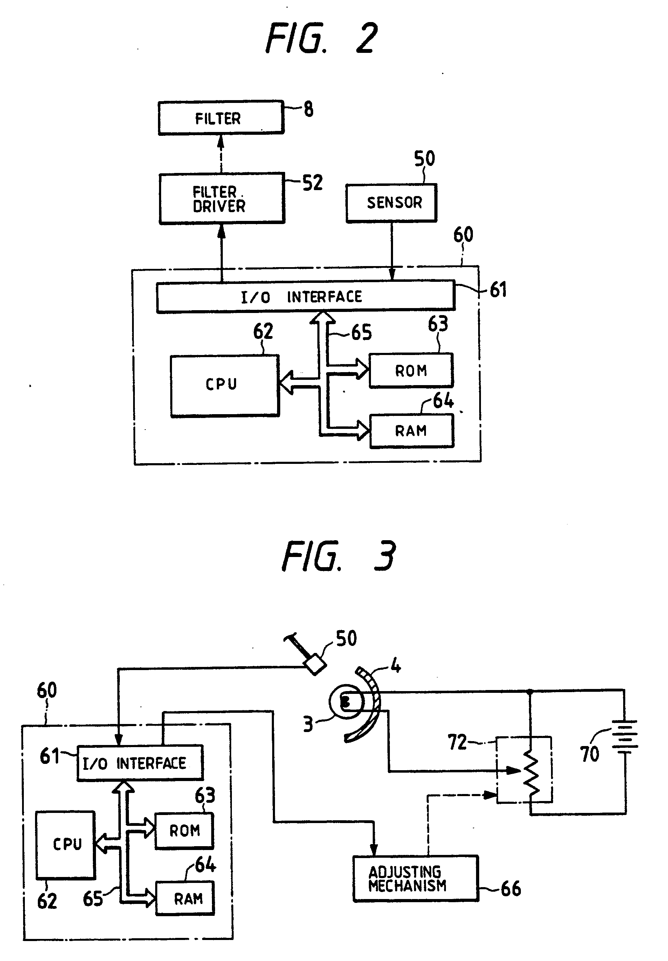

A first embodiment of the present invention will be described with reference to Fig. 2. This embodiment is directed to detection of variation in the performance of the halogen lamps and to compensation therefor by adjusting a filter characteristic.

As shown in Fig. 1, a sensor 50 is disposed between the halogen lamp 3 and the filter unit 8 for sensing a spectrum distribution of the light reflected from the original document. The light reflected therefrom is sensed prior to passing through the filter unit 8. A color temperature sensor is used for the sensor 50, as it is adapted to sense an amount of light of each of read, green and blue components of the light emanated from the halogen lamp 3. However, another type of sensor may be employed depending on the kind of the lamp. As will be described later, the detected value of the spectrum distribution is fed to a microcomputer 60 serving as a control means and the microcomputer 60 adjusts the insertion degree of each filter into the optical path in response thereto. The filter unit 8 typically includes red, green and blue filters which are horizontally movably positioned. These filters are independently movable to traverse the optical path at a desired degree to thus adjust the light amount of each of red, green and blue light components.

In Fig. 1, a white color reference plate 51 is attached to the rear surface in the leftmost position of the original support pane 2. The plate 51 extends in a direction perpendicular to the moving direction of the support pane 2. The light emanated from the halogen lamp 3 is reflected from the reference plate 51, and the sensor 50 senses the spectrum distribution of the light reflected therefrom.

Referring to Fig. 2, a microcomputer 60 includes an input/output interface 61, a CPU 62 serving as an arithmetic means, a ROM 63, a RAM 64, and bus lines connecting those components. The aforethe sensor 50 is coupled to the input/output interface 61 for inputting the detected spectrum distribution data into the microcomputer 60. A filter drive circuit 52 is coupled to the input/output interface 61 for receiving a control signal from the microcomputer 60. In response to the control signal, the filter drive circuit 52 drives each filter.

A table has been stored in the ROM 63, in which insertion amounts of the filters and the spectrum distribution values are correlated. The table is read into the RAM 64 and the CPU 62 gives an optimum insertion amount of each filter corresponding to the spectrum distribution sensed by the sensor 50 while referring to the table. The data regarding the insertion amount are fed through the interface 61 to the filter drive circuit 52, which in turn drives each filter to insert into the optical path.

In operation, with the depression of the start button, the original support pane 2 moves rightwardly and stop in a position where the leftmost end of the support pane 2 confronts the halogen lamp 3. In this condition, the light irradiated from the halogen lamp 3 is reflected from the reference plate 51. The sensor 50 senses the spectrum distribution of the light reflected therefrom, and outputs the resultant data to the microcomputer 60. Referring to the table stored in the ROM 63, an insertion amount of each filter is determined. A signal is then outputted to the filter drive circuit 52. The latter circuit in turn drives each filter so that the imaging light applied to the microcapusule sheet has a desired spectrum distribution.

Therefore, the variation in the spectrum distribution of the light emanated from the halogen lamp and the variation due to aging of the halogen lamp can automatically be compensated for through the adjustment of the filter insertion degrees. The color reproducibility can thus be reliably achievable.

Referring to Fig. 3, a second embodiment of the present invention will be described. The second embodiment is directed to detection of variation in the performance of the halogen lamp and to compensation therefor by adjusting a voltage applied to the halogen lamp.

The circuit shown in Fig. 3 includes a DC power supply 70, a halogen lamp 3 which emits light when a voltage is applied thereto by the DC power supply 70, and a variable resistor 72 for adjusting the voltage applied to the halogen lamp 3. A reflector 4 is disposed behind the halogen lamp 3 for reflecting the light emitted from the lamp 3. As in the first embodiment, the sensor 50 senses a spectrum distribution or a color temperature of the light reflected from the reference plate 51.

A microcomputer 60 is connected to the sensor 50. The microcomputer 60 includes a CPU 62, a ROM 63, a RAM 64, an input/output interface 61 and bus lines connecting those components. The CPU 62 carried out exposure amount adjustment based on a program and correction data stored in the ROM 63. The correction data is read into the RAM 64. The correction data is stored in the form of a table in which the spectrum distribution and the voltage to be applied to the halogen lamp are correlated with each other. The voltage to be applied to the halogen lamp 3 is set so that the amount of light emanated from the halogen lamp 3 is held constant despite the performance of the lamp 3. The spectrum distribution as sensed by the sensor 50 is applied to the input/output interface 61, and in accordance therewith the CPU 62 derives the voltage value from the correction data in the ROM 63. The resultant voltage is outputted to the input/output interface 61. To the input/output interface 61, connected is an adjustment mechanism 66 which adjusts the resistance of the variable resistor 72 so as to be in coincidence with the voltage instructed by the CPU 60. With such an adjustment, the halogen lamp 3 emanates an optimum amount of light having a desired spectrum distribution or color temperature, whereby a stable exposure can be accomplished.

In operation, the sensor 50 senses the spectrum distribution of the light reflected from the reference plate 51 and the resultant value is outputted to the microcomputer 60. In the ROM 62, the correction data has been stored which indicates the voltage to be applied to the halogen lamp corresponding to the spectrum distribution value. When the sensed value from the sensor 50 is inputted to the microcomputer 60, the corresponding voltage value is derived from the table. Data regarding the voltage thus obtained is supplied to the adjustment mechanism 66 which in turn adjusts the resistance of the variable resistor 72. As a result, the amount of light emanated from the halogen lamp 2 is held at substantially constant regardless of the performance of the lamp 3, and thus the exposure can be taken place as intended. The variation in the performance of the halogen lamp and/or the variation of the lamp due to aging do not alter the exposure amount.

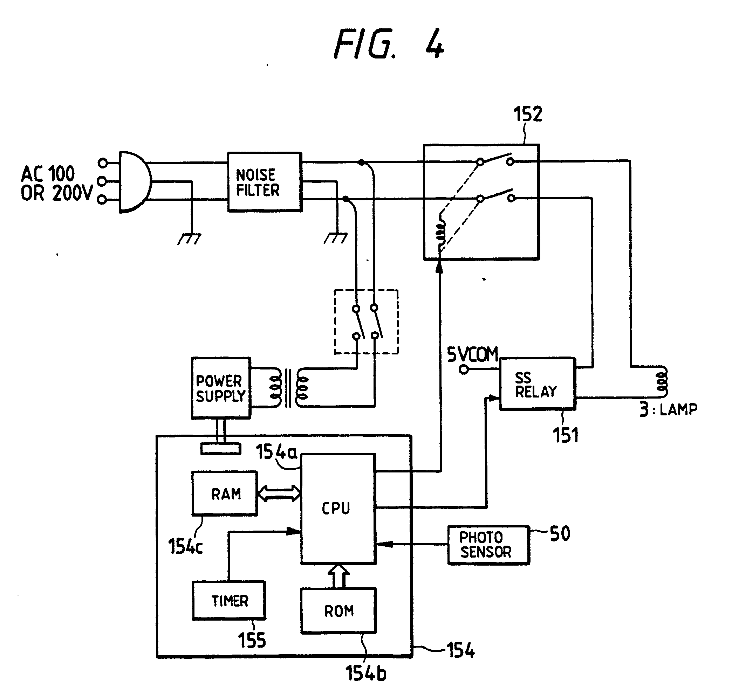

A third embodiment of the present invention will be described with reference to Figs. 4 through 6.

Fig. 4 is a circuit diagram showing an exposure control circuit. The halogen lamp 3 is connected to an AC power supply (100 volts or 200 volts) through an SS relay 151 (first switch means) and a relay 152 (second switch means) connected in series. The SS relay 151 may be a thyristor. The relay 152 has a pair of movable contacts ganged with each other.

The exposure control circuit includes a microcomputer (control means) 154 which receives signals from a photosensor 50 and the start switch. The sensor 50 senses an amount of light emanated from the halogen lamp 3 and outputs a signal indicative of the sensed light amount. The start switch, when depressed, provides a copy start signal instructing to start the copying operation. The microcomputer 154 outputs signals to the relays 151 and 152 for driving the same.

The microcomputer 154 includes a CPU 54a, a ROM 154b, a RAM 154c, and a timer 155. The microcomputer 154 has a function to convert an analog DC voltage to a digital signal. The microcomputer 154 includes a power supply circuit which is powered by the AC power supply through a power switch and a transformer.

With the exposure control thus arranged, the halogen lamp 3 is lit by rendering the relay 152 ON and outputting a lamp drive signal to the SS relay 151 from the output port of the microcomputer 154. The output voltage from the sensor 50 varies depending on the amount of light detected by the sensor 50. The output voltage of the sensor 50 is subjected to analog-to-digital conversion in the microcomputer 154. The light amount of the halogen lamp 3 is controlled by controlling a conduction angle of the SS relay 151 or by implementing a phase control so that the lamp 3 emanates a desired amount of light.

In the case where the output voltage of the sensor 50 is above a predetermined level despite the fact that the lamp drive signal is not ON, the microcomputer 154 determines that the SS relay 151 has been destroyed and retained in ON state, thereby causing the lamp 3 to a runaway condition. The microcomputer 154 therefore renders the relay 152 OFF.

Although a fixing heater and a cooling fan are not depicted in Fig. 4, they are powered by the AC power supply through the relay 152. The relay 152 is normally held in ON state even the lamp 3 has not been lit.

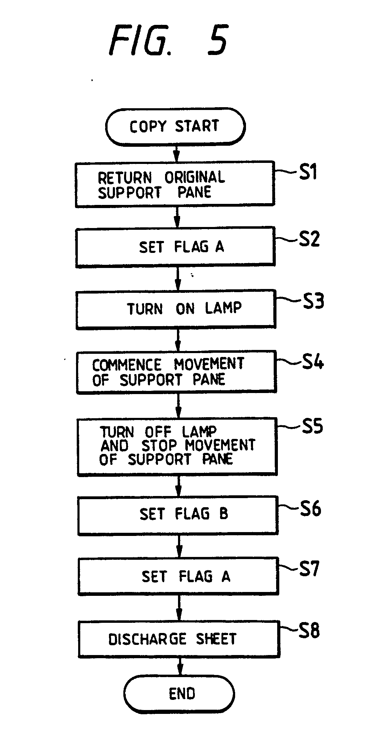

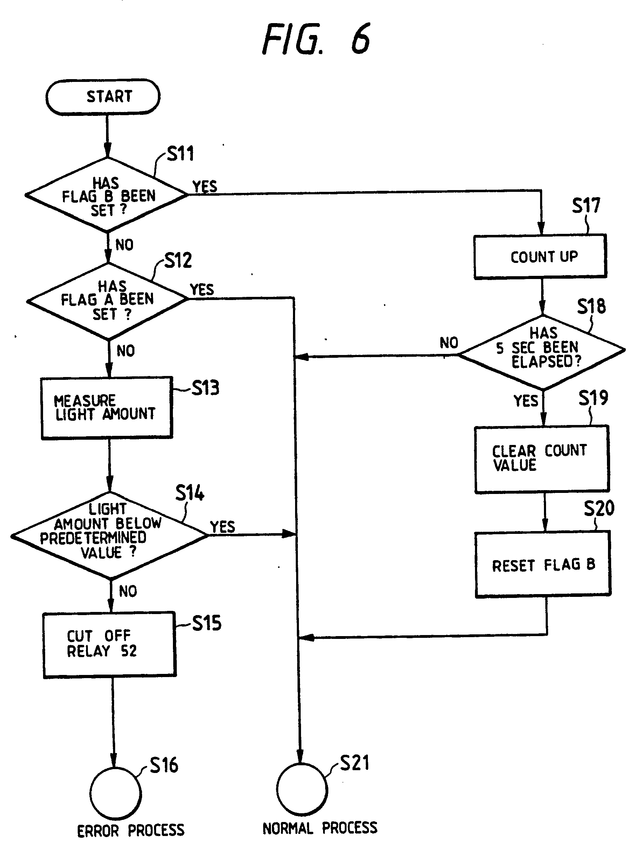

Copying operation and the exposure control operation will be described while referring to flow charts shown in Figs. 5 and 6.

Referring first to Fig. 5, to implement the copying operation, the original support pane is returned to the home position (step 1) and a flag A is set. The flag A is set when the lamp 3 is to be lit. A flag B will later be described, which is set for a period of time, for example, 5 seconds after the lamp 3 is turned off. After the flag A is set, the lamp 3 is turned on (step 3) and the movement of the original support pane is commenced to start exposure (step 4). When the exposure is terminated, the lamp 3 is turned off and the movement of the original support pane is ceased (step 5), whereupon the flag B is set (step 6). Thereafter, the flag A is reset (step 7) and the developer sheet is discharged out of the copying machine (step 8). The copying operation is thus terminated.

The microcomputer 154 performs interruption by the use of the timer 155 at an interval, for example, of 5 miliseconds to thereby detect the light amount of the halogen lamp 3. When both the flags A and B are reset which means that more than 5 seconds have been elapsed after the lamp 3 was turned off, and the sensed light amount is above the predetermined level, the microcomputer 154 determines that the lamp 3 is in the runaway condition, with the result that the relay 152 is rendered OFF and the error process is implemented.

The interrupt routine with the timer is described in the flow chart of Fig. 6. Firstly, it is checked whether or not the flag B has been set (step 11). If no, it is checked whether or not the flag A has been set (step 12). If yes, a normal process is implemented (step 21). In step 11, if the flag B has been set, the timer counts up even if the lamp 3 has just turned off (step 17). Next, it is checked whether or not 5 seconds have been elapsed (step 18). Before the elapse of 5 seconds, the normal process is implemented (step 21) whereas after the elapse of 5 seconds, the count value of the timer is cleared (step 19), the flag B is reset (step 20) and then implements the normal process (step 21).

In step 12, if the flag A has not yet been set, the light amount measurement is performed even in a non-exposure period (step 13) to investigate whether the light amount is below the predetermined level (step 14). If the light amount is below the predetermined level, the normal process is implemented (step 21). If it is not below the predetermined level, the microcomputer 154 determines that the lamp 3 is being in the runaway condition and turns off the relay 152 (step 15), and then implements the error process.

Although it is particularly advantageous to employ as in the above example an electronic switch and a mechanical switch, it can be appreciated to those skilled in the art that another types of switches are also available.

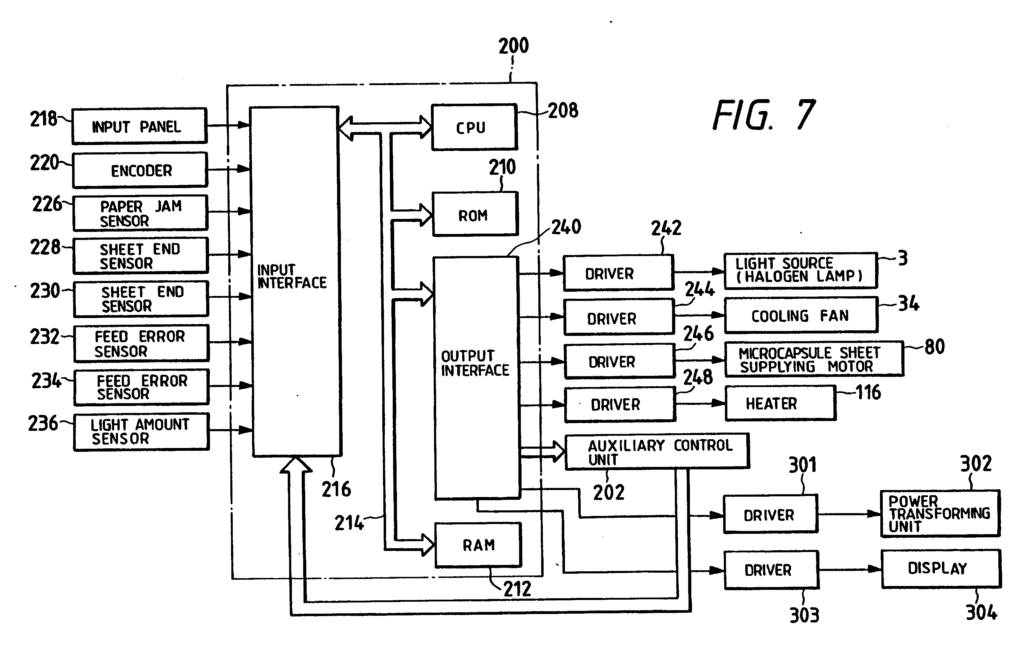

Next, a fourth embodiment of the present invention will be described with reference to Figs. 7 through 9.

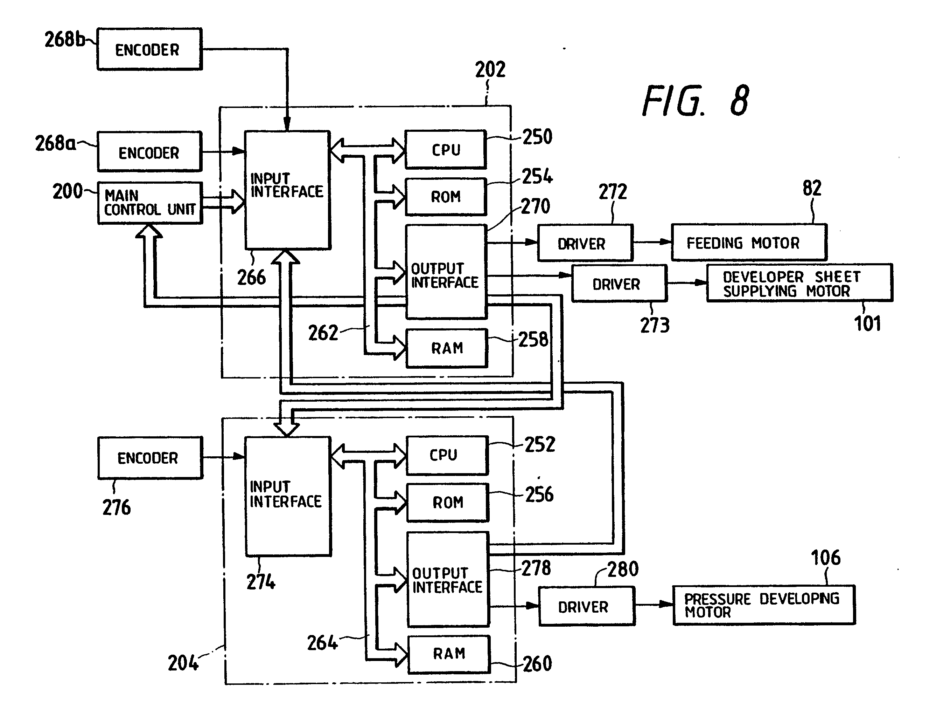

The various parts which make up the copying machine shown in Fig. 1 are controlled by a main control unit 200 shown in Fig. 7, an auxiliary control unit 202 and a pressure developing unit control unit 204 both shown in Fig. 8. Referring to Fig. 7, the main control unit 200 includes a CPU 208, a ROM 210, a RAM 212, an input interface 216, an output interface 240 and bus lines 214 connecting the aforementioned components. To the input interface 216, connected are the output interface 270 of the auxiliary control unit 202, an input panel 218 including data input keys, the copy start switch, etc., an encoder 220 for detecting a rotational angle of a microcapsule sheet supply motor 80 which drives the cartridge shaft 14, and various kinds of sensors. The sensors include a paper jam sensor 226 for sensing paper jam of the microcapsule sheet 37 and/or the developer sheet 38 occurring when these sheet are fed or transported to the relevant positions, sheet end sensors 228, 230 for sensing the ends of the microcapsule sheet 37 and the developer sheet 38, feed error sensors 232, 234 for sensing erroneous feedings of the microcapsule sheet 37 and the developer sheet 38, and a light amount sensor 236 for sensing an amount of light emanated from the light source or the halogen lamp 3. To the output interface 240 of the main control unit 200, connected are the input interface of the auxiliary control unit 202, and the halogen lamp 3, the cooling fan 34, the microcapsule sheet supply motor 80, the heater 116, electric power transporting unit 302 and the display 304 through drivers 242, 244, 246, 248, 301 and 303, respectively. Although not indicated, a moving unit for moving the original support pane 2 is further connected to the output interface of the main control unit 200 through a driver.

Referring to Fig. 8, the auxiliary control unit 202 is constructed with a microcomputer including a CPU 250, a ROM 254, a RAM 258, an input interface 266, an output interface 270 and bus lines connecting those components. To the input interface 266, connected are the output interface of the main control unit 200, the output interface of the pressure developer unit control unit 204, an encoder for sensing a rotational angle of the feeding motor 82 which drives the feed rollers 15, 22, etc., and another encoder 268b for sensing the rotational angle of a developer sheet supply motor 101 which drives the roller 34, registration gate 35, etc. To the output interface 270, connected are the input interface 274 of the pressure developing unit control unit 204, the input interface 216 of the main control unit 200, the feeding motor 82 through a driver 272, and the developer sheet supplying motor 101 through the driver 273.

The pressure developing unit control unit 204 is constructed with a microcomputer including a CPU 252, a ROM 256, a RAM 260, an input interface 274, an output interface 278 and bus lines connecting those components. To the input interface 274, connected are the output interface 270 of the auxiliary control unit 202, and an encoder 276 for sensing the rotational angle of the motor 106 which drives the small-diameter roller 21. To the output interface 278, the input interface 266 of the auxiliary control unit 202 is connected together with the motor 106 through a driver 280.

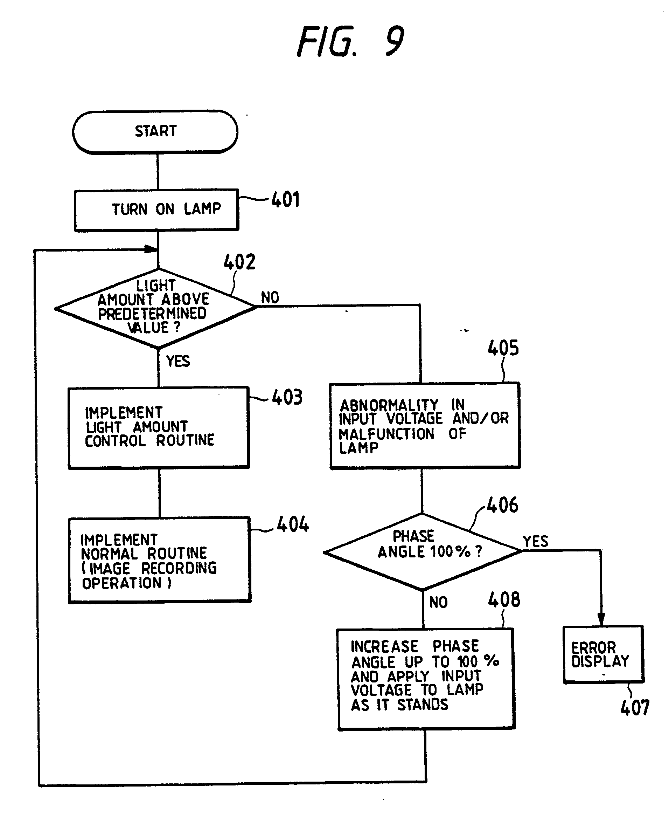

Operation of the control units thus arranged will be described while referring to the flow chart shown in Fig. 9.

The copying machine is placed in a standby condition by the depression of the power supply switch provided on the input panel 218, and the main control unit 200 starts the control operation. When a signal indicative of the depression of the start switch received, the main control unit 200 outputs a drive instruction signal to the driver 242 to thereby turn on the halogen lamp 3 (step 401). After the halogen lamp 3 has been turned on, the main control unit 200 reads a light amount detection signal outputted from the light amount sensor 236, and compares the light amount detection signal with reference data which has been stored in the ROM 210 (step 402). The reference data is determined from the amount of light reflected from the reference plate 51. When it is indicated that the value of the light amount detection signal is above the reference data value, the driver 242 is instructed to output the drive instruction signal to control the driving of the halogen lamp 3 (step 403) so that the light amount detection signal is outputted from the light amount sensor 236 at least during the process in which the original document is scanned. Thereafter, the copying process is implemented (step 404).

In step 402, when it is determined that the value of the light amount detection signal is less than the reference data, decision is made so that a malfunction has been occurring in the halogen lamp 3, such as cut of the filament, otherwise an abnormality of the input voltage has been involved, such as undue lowering of the input voltage (step 405), and the routine advances to step 406. When, in step 402, the light amount detection signal having a lower value than the reference data at the time when the halogen lamp 3 has been controlled to be supplied with input voltage under the phase angle 100% (step 406), the drive instruction signal is outputted to the driver 303 to thereby display the cut of the filament of the halogen lamp 3 or the occurrence of the input voltage abnormality in the display 304 (step 407).

On the other hand, when in step 406, the input voltage is not applied to the halogen lamp 3 with 100% of the phase angle or electrical angle, the drive instruction signal is outputted to the driver 301 to thereby control the power transforming unit 302 so that the electrical angle is increased to 100% to increase the input voltage. For example, provided that the power transforming unit 302 is comprised of a controlled rectifier element, such as a thyristor, the phase of a trigger pulse applied to the gate terminal of the thyristor is adjusted so that the input voltage is supplied totally to the halogen lamp 3 (step 408). Upon performing the control of the power transforming unit 302, the routine returns to step 402.

The first to fourth embodiments of the present invention have been separately described, however, each embodiment can be practiced solely or in combination with the remainder.

Although the present invention has been described with respect to specific embodiments, it will be appreciated by one skilled in the art that a variety of changes and modifications may be made without departing from the scope and spirit of the invention.

For example, although it has been described in the foregoing embodiments that the reference plate is disposed to receive the light emitted from the halogen lamp or the light source, the reference plate can be dispensed with. Instead, the sensor may be disposed to a position capable of directly sensing the light emitted from the light source.

**Claims**

1. A color image recording apparatus for recording an image of an original document on a photosensitive recording medium, the coloring of the image recorded on the recording medium being variable depending on the light applied to the recording medium, the apparatus comprising:

a light source for emitting light to be irradiated onto the original document and reflected from the original document and applied through an optical path to the photosensitive recording medium to form a latent image thereon corresponding to the original document;

sensing means for sensing the light emitted from said light source, and sensing means outputting a detection signal indicative of a quality of the light; and

control means responsive to the detection signal for controlling the light received by the recording medium.

2. Apparatus according to claim 1 including adjusting means disposed in the optical path for adjusting color components of the light reflected from the original document and wherein the control means is for controlling said adjusting means so that the color components of the light reflected from the original document and passing to the recording medium are kept substantially constant, whereby variation in performance of said light source can be compensated for.

3. A color image recording apparatus according to claim 2, wherein said adjusting means comprises a filter unit having a plurality of filter elements each adjusting a respective color component of the light.

4. A color image recording apparatus according to claim 3, wherein said control means includes a memory storing a table in which filtering degrees of the respective filter elements and color temperature values are correlated with each other, said control means controlling the color components of the light reflected from the original document while referring to the table stored in said memory.

5. A color image recording apparatus according to claim 1 including a power supply for supplying a voltage;

the light source being coupled to said power supply for emitting a light depending on the voltage supplied thereto by said power supply and wherein the control means is responsive to the detection signal for controlling the voltage supplied to said light source by said power supply so that the color temperature of the light emitted from said light source is set at a predetermined value, whereby variations in performance of said light source can be compensated for.

6. A color image recording apparatus according to claim 5, wherein said control means includes a memory storing a table in which voltages to be applied to said light source and color temperature values are correlated with each other, said control means in use controlling the voltalge supplied to said light source while referring to the table stored in said memory.

7. A color image recording apparatus according to any preceding claim wherein when the detection signal is less than a predetermined value, said control means determines that a malfunction has occurred.

8. A color image recording apparatus according to any preceding claim and including a or the said power supply and further comprising:
first switch means connected between said power supply and said light source, said first switch means being rendered ON when the image recording is performed otherwise being rendered OFF; and
second switch means connected between said control means and said light source, said second switch means being rendered ON when the image recording is performed;
wherein said first switch means is rendered OFF when said control means determines based on the detection signal that the light is being emitted from said light source out of a period when the image recording is performed.

9. A color image recording apparatus according to any preceding claim wherein the photosensitive recording medium has a surface coated with a large number of microcapsules each encapsulating a photo-curing resin and a chromogenic material of one of three primary colors selected from cyan, magenta and yellow, said microcapsules being photo-curable in response to relevant light components.

10. A color image recording apparatus according to any one of claims 1 to 8 wherein the photosensitive recording medium has a surface coated with a large number of microcapsules each encapsulating a photo-softening resin and a chromogenic material of one of three primary colors selected from cyan, magenta and yellow, the microcapsules being photo-softenable in response to relevant light components.

11. Apparatus according to any preceding claim including a or the power supply, wherein the sensing means senses the amount of light and outputs a signal indicative of the amount and the control means compares the signal with a predetermined value and, when the detection signal is smaller than a predetermined value the control means determines that a malfunction is occurring.

12. A color image recording apparatus for recording an image of an original document on a photosensitive recording medium, the coloring of the image recorded on the recording medium being variable depending on the light applied to the recording medium, the apparatus comprising:
a power supply for supplying a voltage;
a light source coupled to said power supply for emitting light to be irradiated onto the original document and reflected from the original document and applied through an optical path to the photosensitive recording medium to form a latent image thereon corresponding to the original document;
sensing means for sensing the amount of the reflected light, said sensing means outputting a detection signal indicative of the sensed light amount; and
control means responsive to the detection signal for comparing the detection signal with a predetermined value, wherein when the detection signal is smaller than the predetermined value, said control means determines that a malfunction is occurring in at least one of said power supply and said light source.

13. A color image recording apparatus according to claim 7, 11 or 12 further comprising a display for displaying the occurrence of the malfunction.

14. A color image recording apparatus according to claim 11, 12 or 13 further comprising:
first switch means connected between said power supply and said light source, said first switch means being rendered ON when the image recording is performed otherwise being rendered OFF; and
second switch means connected between said control means and said light source, said second switch means being rendered ON when the image recording is performed;
wherein said control means determines based on the detection signal that the light is being emitted from said light source out of a period when the image recording is performed, whereat said second switch means is rendered OFF.

15. A color image recording apparatus according to claim 8 or 14 wherein said first switch means is a mechanical switch and said second switch means is an electronic switch.

16. A color image recording apparatus according to any preceding claim further comprising a reference member disposed to receive the light emitted from said light source, saaid reference member reflecting a reference light indicative of the light emitted from said light source.

17. Apparatus according to any preceding claim wherein said light source commprises a halogen lamp.

EP 0 380 877 A2

# FIG. 1

# FIG. 2

# FIG. 3

FIG. 4

# FIG. 5

```
        ┌─────────────────┐
        │   COPY START    │
        └─────────────────┘
                 │
    ┌────────────────────────┐
    │  RETURN  ORIGINAL      │──── S1
    │  SUPPORT  PANE         │
    └────────────────────────┘
                 │
    ┌────────────────────────┐
    │     SET  FLAG  A       │──── S2
    └────────────────────────┘
                 │
    ┌────────────────────────┐
    │     TURN  ON  LAMP     │──── S3
    └────────────────────────┘
                 │
    ┌────────────────────────┐
    │  COMMENCE  MOVEMENT    │──── S4
    │  OF  SUPPORT  PANE     │
    └────────────────────────┘
                 │
    ┌────────────────────────┐
    │  TURN  OFF  LAMP       │──── S5
    │  AND  STOP MOVEMENT    │
    │  OF  SUPPORT  PANE     │
    └────────────────────────┘
                 │
    ┌────────────────────────┐
    │     SET  FLAG  B       │──── S6
    └────────────────────────┘
                 │
    ┌────────────────────────┐
    │     SET  FLAG  A       │──── S7
    └────────────────────────┘
                 │
    ┌────────────────────────┐
    │   DISCHARGE  SHEET     │──── S8
    └────────────────────────┘
                 │
        ┌─────────────────┐
        │      END        │
        └─────────────────┘
```

# FIG. 6

```
                    START
                      │
                      ▼
                    ┌─S11
         ┌──────────────────────┐
         │        HAS           │    YES
         │   FLAG B BEEN        ├──────────────┐
         │       SET ?          │              │
         └──────────────────────┘              │
                      │ NO                      ▼
                      ▼                      ┌─S17
                    ┌─S12              ┌──────────────┐
         ┌──────────────────────┐     │   COUNT UP   │
         │        HAS           │ YES └──────────────┘
         │   FLAG A BEEN        ├───┐        │
         │       SET ?          │   │        ▼
         └──────────────────────┘   │      ┌─S18
                      │ NO          │  ┌──────────────────┐
                      ▼             │  │       HAS        │  NO
              ┌──────────────┐─S13  │  │   5 SEC BEEN     ├────┐
              │   MEASURE    │      │  │    ELAPSED?      │    │
              │ LIGHT AMOUNT │      │  └──────────────────┘    │
              └──────────────┘      │        │ YES   ─S19      │
                      │             │        ▼                 │
                      ▼             │  ┌──────────────┐         │
                    ┌─S14           │  │ CLEAR COUNT  │         │
         ┌──────────────────────┐  │  │    VALUE     │         │
         │       LIGHT          │  │  └──────────────┘         │
         │   AMOUNT BELOW       │YES│        │ ─S20            │
         │  PREDETERMINED       ├──┐│        ▼                 │
         │      VALUE ?         │  ││  ┌──────────────┐        │
         └──────────────────────┘  ││  │ RESET FLAG B │        │
                      │ NO         ││  └──────────────┘        │
                      ▼            ││        │                 │
              ┌──────────────┐─S15 ││        │                 │
              │   CUT OFF    │     ││        │                 │
              │  RELAY 52    │     ││        │                 │
              └──────────────┘     ││        │                 │
                      │            ▼▼        │                 │
                      ▼          NORMAL      │                 │
                   ╭─────╮─S16   ╭─────╮─S21 │                 │
                   │ ERROR│      │NORMAL│    │                 │
                   ╰─────╯       ╰─────╯     │                 │
                  ERROR PROCESS  NORMAL PROCESS
```

FIG. 7

EP 0 380 877 A2

FIG. 8

# FIG. 9

```
            ┌──────────────┐
            │    START     │
            └──────┬───────┘
                   │
            ┌──────┴───────┐
            │ TURN ON LAMP │───── 401
            └──────┬───────┘
                   │
            ╱──────┴──────╲
           ╱    LIGHT      ╲      402
          ╱  AMOUNT ABOVE   ╲   NO
          ╲  PREDETERMINED  ╱─────────────┐
           ╲   VALUE ?     ╱               │
            ╲──────┬──────╱                │
               YES │                       │
            ┌──────┴───────┐         ┌─────┴────────┐
            │ IMPLEMENT    │── 403   │ ABNORMALITY IN│── 405
            │ LIGHT AMOUNT │         │ INPUT VOLTAGE │
            │ CONTROL      │         │ AND/OR        │
            │ ROUTINE      │         │ MALFUNCTION OF│
            └──────┬───────┘         │ LAMP          │
                   │                 └──────┬────────┘
            ┌──────┴───────┐                │
            │ IMPLEMENT    │── 404     ╱─────┴─────╲
            │ NORMAL ROUTINE│         ╱    PHASE    ╲  406  YES
            │ (IMAGE        │         ╲  ANGLE 100%? ╱──────────┐
            │ RECORDING     │          ╲─────┬─────╱            │
            │ OPERATION )   │             NO │   408           │
            └───────────────┘         ┌──────┴────────┐  ┌──────┴───┐
                                      │ INCREASE PHASE│  │ ERROR    │
                                      │ ANGLE UP TO   │  │ DISPLAY  │
                                      │ 100 % AND     │  └──────┬───┘
                                      │ APPLY INPUT   │      407
                                      │ VOLTAGE TO    │
                                      │ LAMP AS IT    │
                                      │ STANDS        │
                                      └───────────────┘
```